# EUROPÄISCHE PATENTANMELDUNG

(11) **EP 0 817 285 A1**
(43) Veröffentlichungstag der Anmeldung: **07.01.1998**
(21) Anmeldenummer: 97108646.7
(22) Anmeldetag: 28.05.1997
(51) Int. Cl.: H01L 41/09

(54) **Verbund mit piezokeramischen Schichten**

(30) Priorität: 05.07.1996 DE 19627221
(71) Anmelder: Nass Magnet GmbH, D-30179 Hannover (DE)
(72) Erfinder: Hiddessen, Ralf, 31275 Lehrte (DE); Ossenbrügge, Jan-Peter, 30853 Langenhagen (DE)
(74) Vertreter: Tetzner, Michael, Dipl.-Ing.

(57) **Zusammenfassung**

Die Erfindung betrifft einen Verbund aus einer Vielzahl von Schichten, wobei wenigstens jede zweite Schicht als piezokeramische Schicht ausgebildet ist und der piezoelektrische d₃₁-Effekt zur Auslenkung des Verbundes ausgenutzt wird. Erfindungsgemäß bilden jeweils wenigstens zwei Schichten ein Multischichtelement und die gebildeten Multischichtelemente (1a,2a) sind parallel miteinander derart verkoppelt, daß sich die in einem Multischichtelement aufbauenden inneren Zug- bzw. Druckspannungen am Übergang zum nächsten Multischichtelement abbauen können.

## Beschreibung

Die Erfindung betrifft einen Verbund aus einer Vielzahl von Schichten gemäß dem Oberbegriff des Anspruches 1, wobei wenigstens jede zweite Schicht als piezokeramische Schicht ausgebildet ist.

Bei piezokeramischen Werkstoffen handelt es sich um polykristalline Materialien, die in der Lage sind, mechanische Energie in elektrische zu transformieren und umgekehrt. Wird an eine piezokeramische Schicht ein elektrisches Feld angelegt, so entsteht eine elastische Spannung im Kristall, die je nach Polarität des Feldes zu einer Deformation der Schicht, d.h. zu einer Verlängerung bzw. Verkürzung führt. Einen derartigen Effekt zeigen zahlreiche Materialien, wie beispielsweise Bariumtitanat und -zirkonat.

Zur Definition der mechanischen und elektrischen Größen einer piezokeramischen Schicht bedient man sich eines rechtwinkligen x-y-z-Koordinatensystems kristallo-graphischer Achsen, wobei die z-Achse gewöhnlich so gewählt wird, daß sie mit der Richtung der positiven Polarisation zusammenfällt. Diese Koordinatenachsen werden allgemein mit den Ziffern 1, 2 bzw. 3 bezeichnet, die auch als Index bei piezoelektrischen Konstanten verwendet werden, um die Richtungen der mechanischen und elektrischen Größen anzuzeigen.

Die piezoelektrische Ladungskonstante d bezeichnet das Verhältnis zwischen erzeugter Dehnung und angelegter Feldstärke. Man unterscheidet diesbezüglich prinzipiell den d₃₃-Effekt von dem d₃₁-Effekt. Beim d₃₃-Effekt verläuft sowohl die erzeugte Dehnung als auch das angelegte Feld in Richtung der Koordinatenachse 3. Beim d₃₁-Effekt verläuft die erzeugte Dehnung in Richtung 1 und das angelegte Feld senkrecht hierzu in Richtung 3. Bei Anlegen von hohen Betriebsspannungen läßt sich in Richtung des angelegten Feldes eine größere Dehnung erreichen als senkrecht hierzu. Um den d₃₁-Effekt bei niedrigen Betriebsspannungen, insbesondere unter 100 V, sinnvoll ausnutzen zu können, hat man Piezokeramiken mit einer Vielzahl dünner piezoelektrischer Schichten entwickelt. Sie bestehen aus einer Vielzahl von piezokeramischen Schichten, die zur Erzeugung einer Auslenkung des Verbundes elektrisch ansteuerbar sind. Derartige Vielschichtpiezokeramiken werden beispielsweise in der Ultraschalltechnik, der Sensorik und insbesondere auf dem Gebiet der Aktorik eingesetzt. Derartige Wandler bestehen unter Umständen aus 100 und mehr Einzelschichten mit dazwischenliegenden Elektroden, die in einem einzigen gemeinsamen Sinterprozess hergestellt werden. Bei derartigen Vielschicht-Piezokeramiken wird die durch den d₃₁-Effekt erzeugbare Kraft durch die unterschiedliche Ausdehnung übereinander angeordneter Schichten, ähnlich wie beim Thermo-Bimetall, verstärkt.

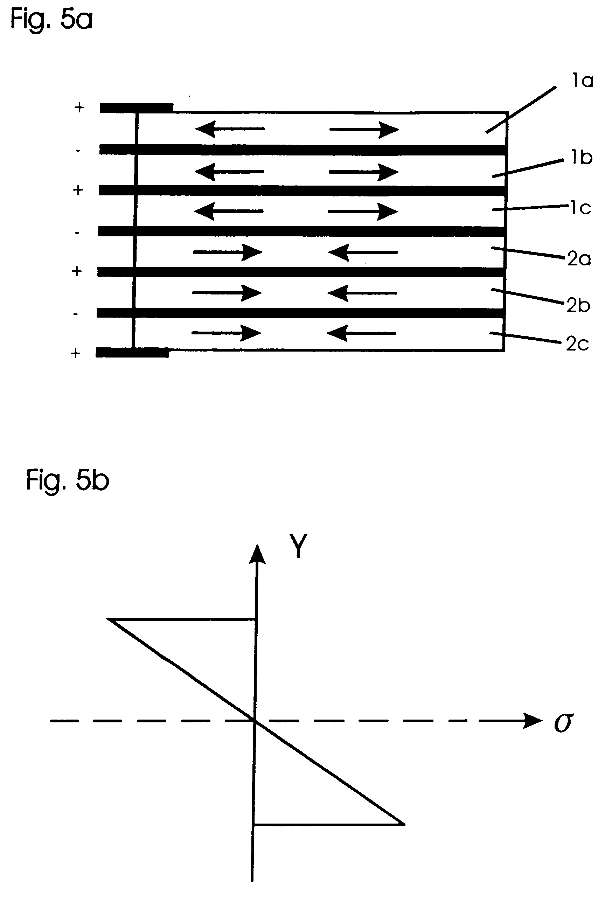

In Fig.5a ist ein aus der Praxis bekanntes Vielschicht-Biegepiezo dargestellt, wobei die Schichten 1a, 1b, 1c der oberen Hälfte derart aufgebaut und mit Spannung beaufschlagt werden, daß sie sich ausdehnen, während sich die Schichten 2a, 2b, 2c der unteren Hälfte bei Anlegung einer Spannung verkürzen. Die dadurch hervorgerufene Auslenkung des Gesamtverbundes kann dann beispielsweise zur Übertragung einer Kraft ausgenutzt werden.

Bei vielen Anwendungen werden hohe Anforderungen an die Zuverlässigkeit dieser Vielschichtpiezokeramiken gestellt. Mit zunehmender Schichtenzahl steigt jedoch auch das Risiko eines Ausfalls. Aufgrund der lokalen inneren mechanischen Spannungen kann es zu Rißbildungen bzw. zum Ablösen einzelner miteinander verbundener Schichten kommen.

Der Erfindung liegt daher die Aufgabe zugrunde, den Verbund gemäß dem Oberbegriff des Anspruches 1 dahingehend weiterzuentwickeln, daß die maximal auftretenden inneren Spannungen reduziert werden, ohne dabei die Leistungsfähigkeit des Verbundes zu beeinträchtigen.

Erfindungsgemäß wird diese Aufgabe durch die kennzeichnenden Merkmale des Anspruches 1 gelöst. Weitere Ausgestaltungen der Erfindung sind Gegenstand der Unteransprüche.

Erfindungsgemäß besteht der Verbund aus einer Vielzahl von Schichten, wobei wenigstens jede zweite Schicht als piezokeramische Schicht ausgebildet ist und jeweils wenigstens zwei Schichten ein Multischichtelement bilden, wobei die gebildeten Multischichtelemente parallel miteinander derart verkoppelt sind, daß sich die in einem Multischichtelement aufbauenden inneren Zug- bzw. Druckspannungen am Übergang zum nächsten Multischichtelement abbauen können.

Weitere Vorteile und Ausgestaltungen der Erfindung sind Gegenstand der Unteransprüche und werden im folgenden anhand einiger Ausführungsbeispiele und der Zeichnung näher erläutert.

In der Zeichnung zeigen
- Fig.1: eine schematische Darstellung eines ersten Ausführungsbeispiels;
- Fig.2: eine schematische Darstellung eines zweiten Ausführungsbeispiels;
- Fig.3: eine schematische Darstellung eines dritten Ausführungsbeispiels;
- Fig.4a: eine schematische Darstellung des in Fig.1 dargestellten Ausführungsbeispiels mit Elektroden;
- Fig.4b: eine Darstellung der Spannungsverhältnisse im Inneren des in Fig.4a dargestellten ersten Ausführungsbeispieles;
- Fig.5a: eine schematische Darstellung eines bekannten Verbundes und
- Fig.5b: eine Darstellung der Spannungsverhältnisse im Inneren des bekannten Verbundes gemäß Fig.5a;
- Fig.6: schematische Darstellung eines vierten Ausführungsbeispieles.

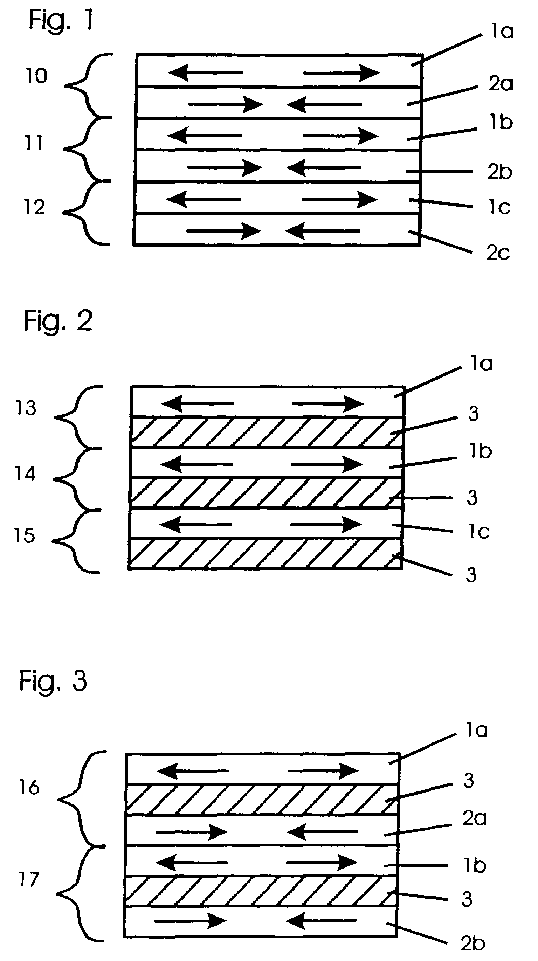

Fig.1 zeigt ein ersten Ausführungsbeispiel eines Verbundes aus einer Vielzahl von piezokeramischen Schichten 1a, 2a, 1b, 2b, 1c, 2c, die derart aufgebaut und elektrisch angesteuert werden, daß sich benachbarte Schichten unterschiedlich deformieren. Unter einer Vielzahl von Schichten im Sinne der Erfindung sind wenigstens vier Schichten zu verstehen.

Wie die Pfeile innerhalb der Schichten andeuten, werden sich die Schichten 1a, 1b und 1c im dargestellten Ausführungsbeispiel ausdehnen, während sich die Schichten 2a, 2b und 2c verkürzen. Ob sich eine piezokeramische Schicht ausdehnt oder verkürzt, hängt zum einen von ihrer Polarisierung und zum anderen von der Polarität der angelegten Spannung ab.

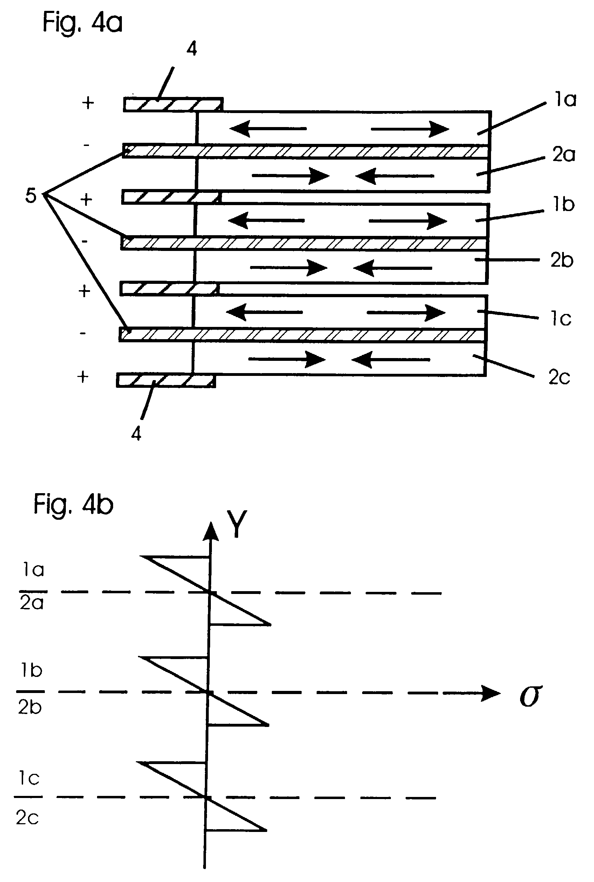

Erfindungsgemäß bilden jeweils wenigstens zwei Schichten ein Multischichtelement, wobei die einzelnen Schichten beispielsweise durch Verkleben miteinander verbunden sind. In Fig.1 sind drei Multischichtelemente 10, 11 und 12 gebildet. Die einzelnen Multischichtelemente sind parallel miteinander derart verkoppelt, daß sich die in einem Multischichtelement aufbauenden inneren Zug- bzw. Druckspannungen am Übergang zum nächsten Multischichtelement abbauen können. Während die Schichten innerhalb eines Multischichtelements vollflächig miteinander verklebt sind, könnte im Bereich zwischen zwei Multischichtelementen, d.h. beispielsweise zwischen den Schichten 2a und 1b lediglich eine Verbindung im Randbereich bestehen, wie das in Fig.4a angedeutet ist. Selbstverständlich können statt der dargestellten sechs Schichten auch beliebig viele weitere Schichten vorgesehen werden, die wiederum in Multischichtelemente zusammengefaßt werden.

Das in Fig.2 dargestellte Ausführungsbeispiel unterscheidet sich von ersterem dadurch, daß zwischen zwei piezokeramischen Schichten jeweils eine passive Metallschicht 3 vorgesehen ist. Auch hier werden durch Verklebung einer piezokeramischen Schicht mit einer Metallschicht Multischichtelemente 13, 14, 15 gebildet. Wird eine piezokeramische Schicht mit einer Metallschicht verbunden, so wird auch hier bei Anlegen einer Spannung eine Deformation in der piezokeramischen Schicht hervorgerufen, so daß es zu einer Krümmung des Multischichtelements kommt. Der Krümmungseffekt ist jedoch nicht so groß wie beim Ausführungsbeispiel gemäß Fig.1.

Auch im dritten Ausführungsbeispiel gemäß Fig.3 ist eine passive Metallschicht 3 vorgesehen, die auf ihren beiden Seiten mit sich entgegengesetzt deformierenden piezokeramischen Schichten 1a, 2a bzw. 1b, 2b fest verbunden wird. Die hier gebildeten Multischichtelemente 16, 17 weisen jeweils drei Schichten auf.

Fig.4a zeigt wiederum das erste Ausführungsbeispiel gemäß Fig.1, wobei zusätzlich die Elektroden 4, 5 zur Ansteuerung der piezokeramischen Schichten 1a bis 2c dargestellt sind. Die Elektroden 4, 5 werden beispielsweise im Siebdruckverfahren mittels metallischer Siebdruckpasten auf die piezokeramischen Schichten aufgebracht.

Zwischen zwei ein Multischichtelement bildende piezokeramische Schichten 1a, 2a; 1b, 2b bzw. 1c, 2c ist jeweils eine Elektrode 5 vollflächig vorgesehen. Die Verbindung zwischen den beiden Schichten und der Elektrode erfolgt in allgemein bekannter Weise, beispielsweise durch Laminieren und Sintern. Auf den Außenseiten jedes Multischichtelements werden beim Herstellungsvorgang zudem auch die Elektroden 4 aufgebracht, die insbesondere auch vollflächig ausgestaltet sind. Die Richtung des angelegten elektrischen Feldes verläuft somit zwischen den Elektroden 4 und 5, d.h. in der Zeichenebene von oben nach unten bzw. unten nach oben. Die Dehnung der piezokeramischen Schichten erfolgt hierzu senkrecht.

Zwischen den einzelnen Multischichtelementen 1a/2a, 1b/2b und 1c/2c ist ein Medium vorgesehen, das bei einer Auslenkung des Verbundes nur geringe Reib- bzw. Scherkräfte zwischen Multischichtelement und Medium hervorruft. Mit anderen Worten sollen zwischen den Schichten 2a, 1b und 2b, 1c möglichst keine Scherkräfte entstehen. Als Medium eignet sich insbesondere Luft. Im einfachsten Fall werden die Multischichtelemente zusammen mit ihren Elektroden übereinander angeordnet, so daß bei einer Deformation der Multischichtelemente eine Relativbewegung zwischen zwei Multischichtelementen stattfinden kann. Auf diese Weise ist sichergestellt, daß die sich innerhalb eines Multischichtelements aufbauenden inneren Zug- bzw. Druckspannungen am Übergang zum nächsten Multischichtelement abbauen und im Idealfall nicht übertragen werden.

Fig.4b zeigt die Druck- bzw. Zugspannungsverhältnisse innerhalb des Verbundes, wobei nach oben der Ort y und nach rechts die Spannung σ aufgetragen ist. Die gestrichelten Linien stellen jeweils die neutralen Fasern dar, die jeweils in der Mitte jedes Multischichtelements 1a/2a, 1b/2b und 1c/2c liegen. Während auf der Oberseite jedes Multischichtelements die maximale Druckspannung auftritt, hat die Zugspannung auf der Unterseite des Multischichtelements ihr Maximum.

Nachdem jedoch zwischen zwei Multischichtelementen eine Relativbewegung möglich ist, erhöhen sich die Druck- und Zugspannungen nicht durch Übereinanderordnung mehrerer Multischichtelemente.

Demgegenüber zeigt der in Fig.5a dargestellte bekannte Verbund aus piezokeramischen Schichten in Fig.5b einen Spannungsverlauf, der deutlich höhere innere Zug- und Druckspannungen aufweist. Bei dem bekannten Verbund gemäß Fig.5a wird die obere Hälfte des Verbundes durch Schichten 1a, 1b, 1c gebildet, die sich bei Spannungsanlegung ausdehnen, während sich die unteren Schichten 2a, 2b, 2c bei Spannungsbeaufschlagung zusammenziehen. Nachdem alle Schichten untereinander vollflächig fest miteinander verbunden sind, kommt es zwangsläufig an den Außenflächen des Verbundes zu sehr hohen Druck- bzw. Zugspannungen, die das Risiko einer Rißbildung bzw. einer Ablösung von Schichten deutlich erhöhen.

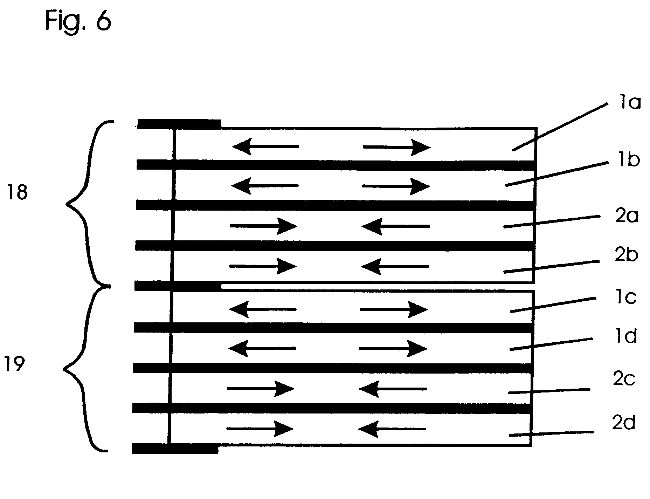

Fig.6 zeigt ein weiteres Ausführungsbeispiel, bei dem die Schichten 1a, 1b, 2a, 2b zu einem ersten Multischichtelement 18 und die Schichten 1c, 1d, 2c, 2d zu einem zweiten Multischichtelement 19 zusammengefügt sind. Während die Schichten innerhalb eines Multischichtelements vollflächig miteinander verbunden sind, ist zwischen den Multischichtelementen 18, 19, d.h. zwischen den Schichten 2b und 1c ein Medium vorgesehen, das eine Relativbewegung der Multischichtelemente zueinander gestattet. Dies kann beispielsweise dadurch erreicht werden, daß die beiden Multischichtelemente lose übereinander angeordnet werden oder lediglich in einem Randbereich miteinander verbunden werden. Dadurch ist wiederum gewährleistet, daß sich die in einem Multischichtelement aufbauenden inneren Zug- bzw. Druckspannungen am Übergang zum nächsten Multischichtelement abbauen können.

Der Aufbau der Multischichtelemente 18, 19 unterscheidet sich von den Ausführungsbeispielen der Fig.1 bis 3 dadurch, daß jeweils zwei Schichten übereinander angeordnet werden, die sich in die gleiche Richtung deformieren.

Erfindungsgemäß werden die Multischichtelemente parallel miteinander verbunden, wobei sich dadurch die Kräfte der einzelnen Multischichtelemente addieren. Die Gesamtkraft eines Verbundes hängt daher wesentlich von der Anzahl seiner Schichten und den hiermit gebildeten Multischichtelementen ab.

Indem der Verbund in mehrere Multischichtelemente unterteilt wird und zwischen diesen Multischichten ein Medium vorgesehen ist, das nur geringe Reib- bzw. Scherkräfte zwischen Multischichtelement und Medium entstehen läßt, kann im Vergleich zum Stand der Technik eine wesentlich höhere Schichtenzahl realisiert werden, da sich die Zug- bzw. Druckspannungen durch Hinzufügen weiterer Multischichtelemente nicht vergrößern. Beim bekannten Stand der Technik ist die Schichtenzahl durch die sich jeweils erhöhenden Druck- bzw. Zugspannungen in den äußeren Schichten begrenzt.

Beim Stand der Technik treten zudem zwischen den Schichten sogenannte Scherkräfte auf, die Verluste darstellen und nicht zuletzt einer Verminderung des mit dem Verbund erreichbaren Drucks darstellen. Da erfindungsgemäß zwischen jeweils zwei Multischichtelementen eine Relativbewegung stattfinden kann, werden insbesondere hier die Scherkräfte und dadurch Reibungsverluste vermieden.

## Patentansprüche

1. Verbund aus einer Viezahl von Schichten, wobei wenigstens jede zweite Schicht als piezokeramische Schicht (1a, 2a, 1b, 2b, ...) ausgebildet ist und der piezoelektrische d₃₁-Effekt zur Auslenkung des Verbundes ausgenutzt wird,
dadurch gekennzeichnet, daß jeweils wenigstens zwei Schichten (1a, 2a; 1b, 2b; ...) ein Multischichtelement (10, ..., 19) bilden und die gebildeten Multischichtelemente parallel miteinander derart verkoppelt sind, daß sich die in einem Multischichtelement aufbauenden inneren Zug- bzw. Druckspannungen am Übergang zum nächsten Multischichtelement abbauen können.

2. Verbund nach Anspruch 1, dadurch gekennzeichnet, daß die einzelnen Schichten eines Multischichtelements auf ihren zugewandten Flächen vollflächig miteinander verbunden sind.

3. Verbund nach einem der vorhergehenden Ansprüche, dadurch gekennzeichnet, daß zwischen zwei Multischichtelementen ein Medium vorgesehen ist, das eine Relativbewegung der Multischichtelemente zueinander gestattet.

4. Verbund nach einem der vorhergehenden Ansprüche, dadurch gekennzeichnet, daß zwischen zwei Multischichtelementen ein Medium vorgesehen ist, das bei Auslenkung des Verbundes nur geringe Reib- bzw. Scherkräfte zwischen Multischichtelement und Medium hervorruft.

5. Verbund nach einem der vorhergehenden Ansprüche, dadurch gekennzeichnet, daß benachbarte Schichten derart aufgebaut sind und wenigstens eine der beiden Schichten derart ansteuerbar ist, daß die beiden Schichten unterschiedlich deformiert werden.

6. Verbund nach einem der vorhergehenden Ansprüche, dadurch gekennzeichnet, daß jede Schicht als piezokeramische Schicht ausgebildet ist.

7. Verbund nach Anspruch 6, dadurch gekennzeichnet, daß benachbarte Schichten (1a, 2a; 1b, 2b; ...) des Verbundes derart aufgebaut und elektrisch ansteuerbar sind, daß eine entgegengesetzte Deformation der beiden Schichten bewirkt wird.

8. Verbund nach einem der vorhergehenden Ansprüche, dadurch gekennzeichnet, daß die piezokeramischen Schichten zur elektrischen Ansteuerung Elektroden (4, 5) aufweisen.

9. Verbund nach Anspruch 3 oder 4, dadurch gekennzeichnet, daß als Medium Luft vorgesehen ist.

10. Verbund nach einem der vorhergehenden Ansprüche, dadurch gekennzeichnet, daß alle piezokeramischen Schichten in der gleichen Richtung polarisiert sind.

11. Verbund nach Anspruch 8, dadurch gekennzeichnet, daß zwischen zwei piezokeramischen Schichten lediglich eine Elektrode (4, 5) vorgesehen ist, durch die beide Schichten ansteuerbar sind.
